# EUROPEAN PATENT APPLICATION

(11) **EP 4 134 860 A1**
(43) Date of publication of application: **15.02.2023**
(21) Application number: 21190956.9
(22) Date of filing: 12.08.2021
(51) Int. Cl.: G06F 30/10, G06T 7/50, G06N 3/04

(54) **REALISTIC DEPTH IMAGE GENERATION USING GENERATIVE ADVERSARIAL NETS**

(71) Applicant: Siemens Aktiengesellschaft, 80333 München (DE)
(72) Inventor: XIA, Wei Xi, Daly City, 94015 (US); SOLOWJOW, Eugen, Berkeley, 94709 (US); TAMASKAR, Shashank, Davis, 95618 (US); APARICIO OJEA, Juan L., Moraga, 94556 (US); CLAUSSEN, Heiko, Wayland, 01778 (US); UGALDE DIAZ, Ines, Redwood City, 94061 (US); SHAHAPURKAR, Yash, Berkeley, 94704 (US); SATHYA NARAYANAN, Gokul Narayanan, Emeryville, 94608 (US); WEN, Chengtao, Redwood City, 94065 (US)
(74) Representative: Horn Kleimann Waitzhofer Patentanwälte PartG mbB

(57) **Abstract**

System and method are disclosed for training a generative adversarial network pipeline that can produce realistic artificial depth images useful as training data for deep learning networks used for robotic tasks. A generator network receives a random noise vector and a computer aided design (CAD) generated depth image and generates an artificial depth image. A discriminator network receives either the artificial depth image or a real depth image in alternation, and outputs a predicted label indicating a discriminator decision as to whether the input is the real depth image or the artificial depth image. Training of the generator network is performed in tandem with the discriminator network as a generative adversarial network. A generator network cost function minimizes correctly predicted labels, and a discriminator cost function maximizes correctly predicted labels.

## Description

### TECHNICAL FIELD

This application relates to machine learning. More particularly, this application relates to a generative adversarial network pipeline that can produce realistic depth images useful as training data for deep learning networks.

### BACKGROUND

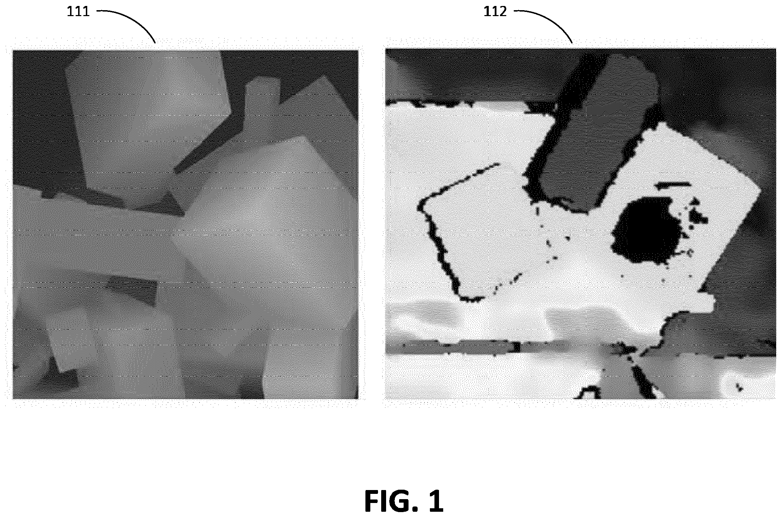

Depth images are useful in industrial automation (e.g., robotics) for tasks such as object identification, obstacle avoidance, and grasp planning. Depth scan sensors or cameras are typically deployed on or near a robot to assist the robot with depth perception as it performs its tasks. With the advancement in deep learning and imaging products (e.g. the Intel Realsense RGB-D camera), machine learning-based models are often trained using depth images as input data for achieving those tasks. Training these models requires a large amount of training data, such as thousands of depth images that are expensive to gather and label. To accelerate the data gathering, depth images can be artificially created from 3D CAD models such as image 101 shown in FIG. 1 using existing software tools. While such depth images can be amassed quickly and easily because they are artificially generated with the assistance of software tools, such artificial depth images fall well short of representing realistic depth images for lack of noise characteristics typically present in the real-world depth images. Training machine learning model with unrealistic depth images is not effective for generalizing in real-world settings. Because noise can significantly alter the depth occlusion boundaries in a depth image, the training of the robot with inferior training data can fail to mimic real-world conditions leading to robotic failures when performing visually controlled operative tasks. There is a need for quickly creating a large number of realistic artificial depth images with realistic noise characteristics and for training generalizable machine learning models.

One current solution calls for generating Gaussian noise that can be added to the depth images. However, the real-world noise does not demonstrate any easily definable distribution and is often biased due to different environmental factors such as the lighting condition, temperature, surface imperfections, and reflectivity of materials (e.g., image 102 shown in FIG. 1). Therefore, simply adding noise according to a specific distribution, such as according to a Gaussianbased distribution, will not create a realistic depth image. Another current solution involves characterizing the noise of the camera using traditional data science techniques, and then applying the custom noise to the artificial data prior to model training. For example, a neural network can be trained with hardware and environmental parameters to predict the noises which can subsequently be superimposed on the depth image. This, however, presents two main drawbacks. First, the process of accurately characterizing the noise of the camera as some custom distribution is very laborious and offers no guarantees on the suitability of the trained models for the real world. Second, the noise is highly dependent on the camera (hardware) being used and the physical setup where it is installed. Therefore, the laborious process would have to be repeated for every new camera and setup.

### SUMMARY

In an aspect, a system generates realistic artificial depth images suitable for robotic task training data. The system includes a memory having modules stored thereon and a processor for performing executable instructions in the modules stored on the memory. The modules include a generator network configured as first neural network to receive a pair of data inputs: a random noise vector and a computer aided design (CAD) generated depth image. The output of the generator network is an artificial depth image. A discriminator network is configured as a second neural network to receive a single data input that includes the artificial depth image and a real depth image in alternation. The output of the discriminator network is a predicted label indicating a discriminator decision as to whether an instant input is more likely the real depth image or the artificial depth image. During training of the generator network, the first and second neural networks are trained in tandem as a generative adversarial network according to a minibatch stochastic gradient descent process. Weights of the first and second neural networks are alternately updated to optimize a first cost function of the first neural network and a second cost function of the second neural network. The first cost function minimizes correctly predicted labels by the discriminator network and the second cost function maximizes correctly predicted labels by the discriminator network. A plurality of training iterations is executed until the discriminator network is unable to discern the difference between a real depth image and an artificial depth image. Upon training completion, the generator is configured to generate a plurality of realistic artificial depth images given new input data that includes random noise vectors and CAD generated depth images.

### BRIEF DESCRIPTION OF THE DRAWINGS

Non-limiting and non-exhaustive embodiments of the present embodiments are described with reference to the following FIGURES, wherein like reference numerals refer to like elements throughout the drawings unless otherwise specified.
FIG. 1 shows examples of a depth images obtained by conventional means.
FIG. 2 shows an example of a computing environment used to operate a generative adversarial network in accordance with embodiments of this disclosure.
FIG. 3 shows a block diagram for an example of a generative adversarial network in accordance with embodiments of this disclosure.
FIG. 4 shows an example of a computing environment within which embodiments of the disclosure may be implemented.

### DETAILED DESCRIPTION

System and method are disclosed for providing realistic artificial depth images useful for training deep learning networks used in automated robotic tasks, such as an automated production or assembly process in industry. An objective to generate training data for a robot that is targeted to perform automated tasks at a particular workstation environment using depth sensors to execute manipulations (e.g., grasping) on a work product. To train the robot to perform its work tasks according to depth scan sensor inputs, deep learning networks are utilized, which in turn require a large number of images as training data. Instead of generating artificial depth images with Gaussian noise added for mimicking real depth images, the disclosed system and method provide a novel approach that relies on a generative adversarial network pipeline that is better suited for modeling artificial depth images with realistic noise characteristics. This new modeling approach reliably and quickly derives realistic depth images without the time consuming and inaccurate aspects of manually defining noise distributions related to the target work station environment.

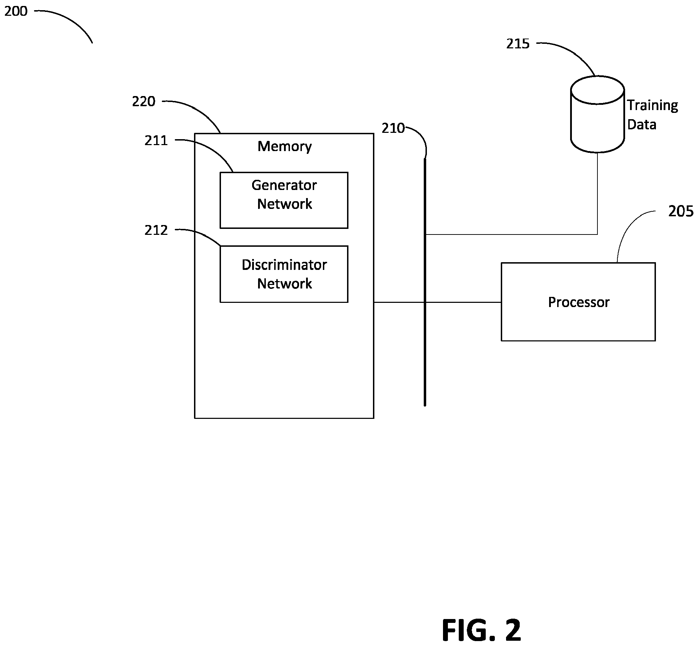

FIG. 2 shows a block diagram of a computing environment for implementing the embodiments of this disclosure. A computing system 200 includes a memory 220, a system bus 210, and a processor 205. Generator network (GN) 211 is a neural network stored as a program module in memory 220. Discriminator network (DN) 221 is a neural network stored as a program module in memory 220. Processor 205 executes the modules 211, 221 to perform the functionality of the disclosed embodiments. Training data 215 used to train the neural networks may be stored locally or may be stored remotely, such as in a cloud-based server, accessible via a network interface. Training data may include real depth images obtained from a depth scan sensor or camera, artificial noise generated by a random noise generator, and computer aided design (CAD) generated depth images created from 3D CAD models using software tools. In an alternative embodiment, GN 211 and DN 221 may be deployed in a cloud-based server and accessed by computing system 200 using a network interface.

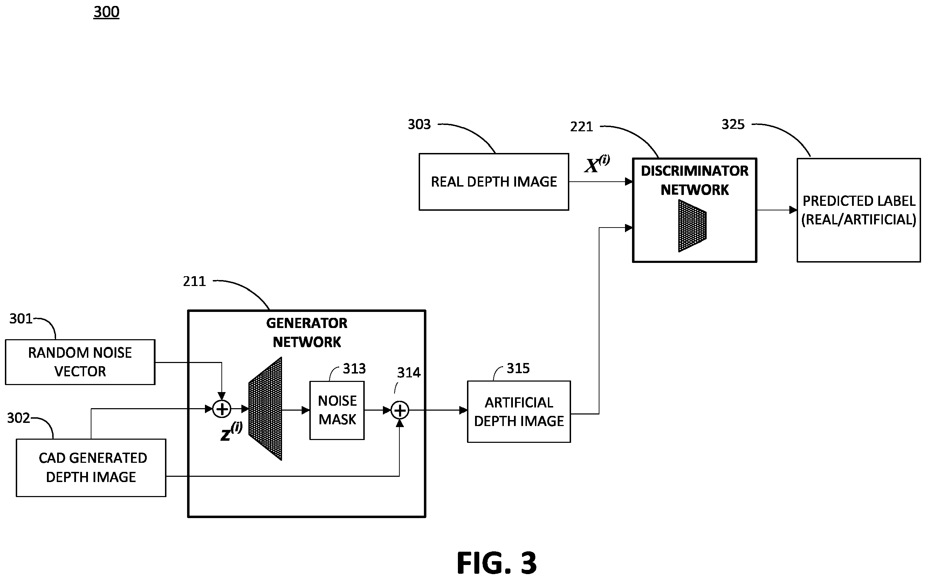

FIG. 3 shows an example of a pipeline for a generative adversarial network (GAN) in accordance with embodiments of this disclosure. GAN pipeline 300 is a generative model that can learn complex distributions and then generate novel outputs accordingly. In general, GANs are proven effective in generating novel human faces, forming natural landscapes, and inpainting photos, etc. The objective is to train GN 211 with readily available input data so that upon being trained, GN 211 can operate to produce the desired realistic depth images. Training GN 211 involves training two neural networks, GN 211 and DN 221, in tandem with cost functions that force the two networks 211, 221 to compete as adversarial networks. The training process can be summarized as follows.

Training data 215 is generated and stored in a memory or data bank. The training data provides inputs to the GAN pipeline 300. As a first input, random noise vectors 301 can be generated from a random noise generator and applied directly in real time as input, or can be first stored as training data 215 and then accessed by GAN pipeline 300. As a second input, CAD generated depth images 302 generated artificially from 3D CAD models are supplied to GN 211. Based on the inputs, GN 211 fabricates a noise mask 313 that models a 2D noise distribution bounded by the 2D dimensions of CAD generated depth images 302. Artificial depth image 315 is generated by adding the noise mask 313 to CAD generated depth images 302. These artificial depth images 315, along with real depth images 303, are fed in alteration into DN 221. Real depth images 303 capture the target work environment and may be obtained using a depth scan sensor aimed at the target work environment (e.g., an automation robot equipped with a depth scan camera positioned in the planned workstation programmed to capture a set of sample images at various angles). Alternatively, a handheld depth scan camera can be used to capture a set of depth images 303. The minimum number of images collected depends on different environmental factors and geometries of the objects in the target scene (e.g., automation workstation), and can approximately range between 100 to 1000 images. The function of DN 221 is to receive a sample input and to discriminate as to which class it belongs, either belonging to the real depth images 303 or the artificial depth images 315. The pipeline 300 is repeatedly operated for multiple iterations until the quality of the generated artificial depth images 315 is indiscernible from the real depth images 303 as viewed by DN 221. Inputs to DN 221 are received in alternation between real depth images 303 and artificial depth images (e.g., alternation may be random or according to a defined pattern). For each input instance, DN 221 produces a predicted label 325 that indicates a discriminator decision as to whether the instant input is more likely a real input 303 or an artificial input 315. Cost functions for are exactly opposite, (hence adversarial for the GAN operation). Cost function of GN 211 minimizes the correctly predicted labels, forcing DN 221 to refine discrimination decisions and improve precision, whereas DN 221 cost function maximizes correctly predicted labels. The training is completed when DN 221 can no longer discern between the artificial depth images and the real. For example, the training can be determined to be completed when quality of generated artificial depth images 315 is such that the error rate for the predicted labels reaches about 50%. Such an error rate is an indication that model parameters in GN 211 are adequately learned to generate realistic depth images with realistic noise.

An objective of GN 211 is to be trained to summarize a data distribution for an input variable, enabling GN 211 to generate new variables that can fit into the distribution of the input variable. In the particular use case at hand, GN 211 learns to model a noise distribution, shown as noise mask 313 that represents variable noise for simulated depth scans, well enough to generate new examples of simulated depth images that fit the same distribution when masked with random noise.

In an embodiment, training of GN 211 is achieved by operating the GAN pipeline 300 as follows. The neural networks of GN 211 and DN 221 are trained according to a minibatch stochastic gradient descent process, which can be expressed by Algorithm 1 based on a vanilla GAN approach: 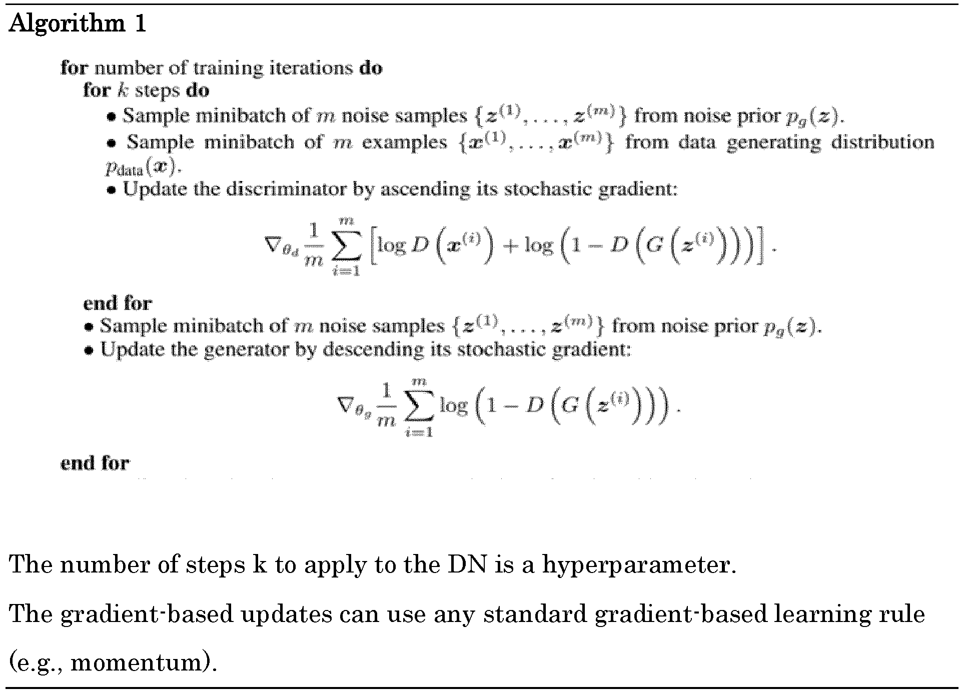 A set of real-world depth images 303 are collected as input **x**⁽ⁱ⁾ to the DN 221. The process of alternately updating the weights of DN 221 and GN 211 will optimize their cost functions, respectively. However, the input to GN 211 cannot be simply a random noise vector 301. A CAD generated depth image 302 also needs to be attached to the noise vector 301 as an input **(z⁽ⁱ⁾)**. Additionally, the noise mask 313 generated by GN 211 is not directly fed into the DN 221. Instead, the noise mask 313 output by GN 211 is superimposed onto the same CAD generated depth image 302 to produce the final artificial depth image 315. For example, the operator 314 for the combination may be a sum, as shown in FIG. 3, or a product.

After being fully trained according to the above training process, GN 211will be able to receive a CAD generated depth image 302 with any random noise vector 301 and produce a corresponding noisy depth image 315. DN 221 is not needed for this stage as its service in GAN 300 was only necessary during the training of parameters in GN 211. Using this novel method, a virtually unlimited supply of realistic depth images 315 can be rapidly generated by the trained GN 211. These realistic depth images 315 are useful to train other neural networks and machine learning models, such as elsewhere within the automation system in which the simulated depth scan exists, or for later projects with related setups.

An advantage of the disclosed embodiments is the ability of GAN 300 to produce realistic depth images. Noise is not simply added to a sample depth image based on a particular distribution such as the Gaussian noise, but instead based on the training sample's distribution. For a robotics application, there often is a complex environmental condition (i.e., lighting, materials, and depth camera quality). Generating a realistic depth image based on an environmental model is just not feasible. Using GAN 300, a set of real-world depth images can be easily collected based on the robot cell setup, capturing a small number of real depth images 303 using existing sensors or with a portable camera, and GAN 300 training is a fully automated, streamlined and relatively quick process. The resulting artificial images 315 from trained GN 211 will be as realistic as if taken with the same robot cell setup.

While known solutions include development of a noise model manually based on the environment, such an approach is very time consuming and difficult to capture all the underlying distributions accurately due to a multitude of factors, including modeling of light sources, shadowing, and occlusions. On top of this, the environment is likely to change over time, requiring a time consuming model update. GAN 300 makes use of neural networks that are effective in learning distributions and generalizing them. This property saves significant time because training data need only include examples that are representative of the workstation environment in order to generate realistic depth images. In an embodiment, in response to changes to the workstation environment or setup which may occur after some time period following the training (e.g., modifications made to a robotic automation production line to suit a new product assembly), the above training process can be repeated in a short amount of time by obtaining a new set of real depth images from a depth scan camera aimed at the workstation scene, and then reusing the training data as inputs to the GAN pipeline 300 to reconfigure the GN 211 parameter distribution through a retraining process. Once the retraining is completed, new realistic artificial depth images can be generated for retraining deep learning networks used for the target robotic tasks.

GAN 300 disclosed herein can be extended to other deep learning applications for industrial processes that requires perception and prediction. For example, neural network inferences on the programmable logic controller (PLC) level require an arsenal of pre-trained neural networks that provide useful models for different applications. Such models can be supported by the GAN's capability to generate a tremendous amount of data needed for training such neural networks.

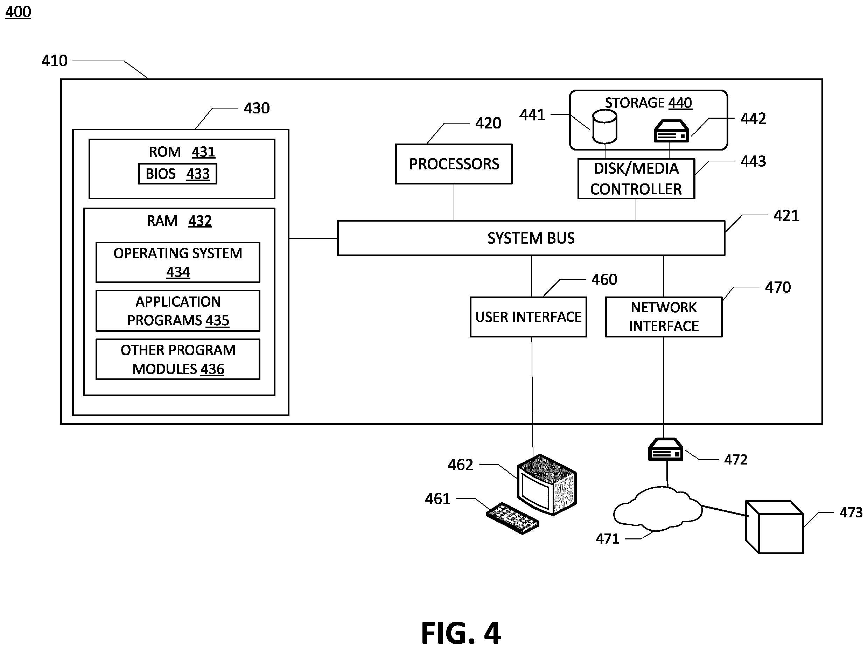

FIG. 4 illustrates an example of a computing environment within which embodiments of the present disclosure may be implemented. A computing environment 400 includes a computer system 410 that may include a communication mechanism such as a system bus 421 or other communication mechanism for communicating information within the computer system 410. The computer system 410 further includes one or more processors 420 coupled with the system bus 421 for processing the information. In an embodiment, computing environment 400 corresponds to a system for realistic artificial depth image generation, in which the computer system 410 relates to a computer described below in greater detail.

The processors 420 may include one or more central processing units (CPUs), graphical processing units (GPUs), or any other processor known in the art. More generally, a processor as described herein is a device for executing machine-readable instructions stored on a computer readable medium, for performing tasks and may comprise any one or combination of, hardware and firmware. A processor may also comprise memory storing machine-readable instructions executable for performing tasks. A processor acts upon information by manipulating, analyzing, modifying, converting or transmitting information for use by an executable procedure or an information device, and/or by routing the information to an output device. A processor may use or comprise the capabilities of a computer, controller or microprocessor, for example, and be conditioned using executable instructions to perform special purpose functions not performed by a general purpose computer. A processor may include any type of suitable processing unit including, but not limited to, a central processing unit, a microprocessor, a Reduced Instruction Set Computer (RISC) microprocessor, a Complex Instruction Set Computer (CISC) microprocessor, a microcontroller, an Application Specific Integrated Circuit (ASIC), a Field-Programmable Gate Array (FPGA), a Systemon-a-Chip (SoC), a digital signal processor (DSP), and so forth. Further, the processor(s) 420 may have any suitable microarchitecture design that includes any number of constituent components such as, for example, registers, multiplexers, arithmetic logic units, cache controllers for controlling read/write operations to cache memory, branch predictors, or the like. The microarchitecture design of the processor may be capable of supporting any of a variety of instruction sets. A processor may be coupled (electrically and/or as comprising executable components) with any other processor enabling interaction and/or communication there-between. A user interface processor or generator is a known element comprising electronic circuitry or software or a combination of both for generating display images or portions thereof. A user interface comprises one or more display images enabling user interaction with a processor or other device.

The system bus 421 may include at least one of a system bus, a memory bus, an address bus, or a message bus, and may permit exchange of information (e.g., data (including computer-executable code), signaling, etc.) between various components of the computer system 410. The system bus 421 may include, without limitation, a memory bus or a memory controller, a peripheral bus, an accelerated graphics port, and so forth. The system bus 421 may be associated with any suitable bus architecture including, without limitation, an Industry Standard Architecture (ISA), a Micro Channel Architecture (MCA), an Enhanced ISA (EISA), a Video Electronics Standards Association (VESA) architecture, an Accelerated Graphics Port (AGP) architecture, a Peripheral Component Interconnects (PCI) architecture, a PCI-Express architecture, a Personal Computer Memory Card International Association (PCMCIA) architecture, a Universal Serial Bus (USB) architecture, and so forth.

Continuing with reference to FIG. 4, the computer system 410 may also include a system memory 430 coupled to the system bus 421 for storing information and instructions to be executed by processors 420. The system memory 430 may include computer readable storage media in the form of volatile and/or nonvolatile memory, such as read only memory (ROM) 431 and/or random access memory (RAM) 432. The RAM 432 may include other dynamic storage device(s) (e.g., dynamic RAM, static RAM, and synchronous DRAM). The ROM 431 may include other static storage device(s) (e.g., programmable ROM, erasable PROM, and electrically erasable PROM). In addition, the system memory 430 may be used for storing temporary variables or other intermediate information during the execution of instructions by the processors 420. A basic input/output system 433 (BIOS) containing the basic routines that help to transfer information between elements within computer system 410, such as during start-up, may be stored in the ROM 431. RAM 432 may contain data and/or program modules that are immediately accessible to and/or presently being operated on by the processors 420. System memory 430 may additionally include, for example, operating system 434, application modules 435, and other program modules 436. Application modules 435 may include aforementioned modules described for FIG. 1 and may also include a user portal for development of the application program, allowing input parameters to be entered and modified as necessary.

The operating system 434 may be loaded into the memory 430 and may provide an interface between other application software executing on the computer system 410 and hardware resources of the computer system 410. More specifically, the operating system 434 may include a set of computer-executable instructions for managing hardware resources of the computer system 410 and for providing common services to other application programs (e.g., managing memory allocation among various application programs). In certain example embodiments, the operating system 434 may control execution of one or more of the program modules depicted as being stored in the data storage 440. The operating system 434 may include any operating system now known or which may be developed in the future including, but not limited to, any server operating system, any mainframe operating system, or any other proprietary or non-proprietary operating system.

The computer system 410 may also include a disk/media controller 443 coupled to the system bus 421 to control one or more storage devices for storing information and instructions, such as a magnetic hard disk 441 and/or a removable media drive 442 (e.g., floppy disk drive, compact disc drive, tape drive, flash drive, and/or solid state drive). Storage devices 440 may be added to the computer system 410 using an appropriate device interface (e.g., a small computer system interface (SCSI), integrated device electronics (IDE), Universal Serial Bus (USB), or FireWire). Storage devices 441, 442 may be external to the computer system 410.

The computer system 410 may include a user input/output interface module 460 to process user inputs from user input devices 461, which may comprise one or more devices such as a keyboard, touchscreen, tablet and/or a pointing device, for interacting with a computer user and providing information to the processors 420. User interface module 460 also processes system outputs to user display devices 462, (e.g., via an interactive GUI display).

The computer system 410 may perform a portion or all of the processing steps of embodiments of the invention in response to the processors 420 executing one or more sequences of one or more instructions contained in a memory, such as the system memory 430. Such instructions may be read into the system memory 430 from another computer readable medium of storage 440, such as the magnetic hard disk 441 or the removable media drive 442. The magnetic hard disk 441 and/or removable media drive 442 may contain one or more data stores and data files used by embodiments of the present disclosure. The data store 440 may include, but are not limited to, databases (e.g., relational, object-oriented, etc.), file systems, flat files, distributed data stores in which data is stored on more than one node of a computer network, peer-to-peer network data stores, or the like. Data store contents and data files may be encrypted to improve security. The processors 420 may also be employed in a multi-processing arrangement to execute the one or more sequences of instructions contained in system memory 430. In alternative embodiments, hard-wired circuitry may be used in place of or in combination with software instructions. Thus, embodiments are not limited to any specific combination of hardware circuitry and software.

As stated above, the computer system 410 may include at least one computer readable medium or memory for holding instructions programmed according to embodiments of the invention and for containing data structures, tables, records, or other data described herein. The term "computer readable medium" as used herein refers to any medium that participates in providing instructions to the processors 420 for execution. A computer readable medium may take many forms including, but not limited to, non-transitory, non-volatile media, volatile media, and transmission media. Non-limiting examples of non-volatile media include optical disks, solid state drives, magnetic disks, and magneto-optical disks, such as magnetic hard disk 441 or removable media drive 442. Non-limiting examples of volatile media include dynamic memory, such as system memory 430. Non-limiting examples of transmission media include coaxial cables, copper wire, and fiber optics, including the wires that make up the system bus 421. Transmission media may also take the form of acoustic or light waves, such as those generated during radio wave and infrared data communications.

Computer readable medium instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to illustrations of methods, apparatus (systems), and computer program products according to embodiments of the disclosure. It will be understood that each block of the illustrations, and combinations of blocks in the illustrations, may be implemented by computer readable medium instructions.

The computing environment 400 may further include the computer system 410 operating in a networked environment using logical connections to one or more remote computers, such as remote computing device 473. The network interface 470 may enable communication, for example, with other remote devices 473 or systems and/or the storage devices 441, 442 via the network 471. Remote computing device 473 may be a personal computer (laptop or desktop), a mobile device, a server, a router, a network PC, a peer device or other common network node, and typically includes many or all of the elements described above relative to computer system 410. When used in a networking environment, computer system 410 may include modem 472 for establishing communications over a network 471, such as the Internet. Modem 472 may be connected to system bus 421 via user network interface 470, or via another appropriate mechanism.

Network 471 may be any network or system generally known in the art, including the Internet, an intranet, a local area network (LAN), a wide area network (WAN), a metropolitan area network (MAN), a direct connection or series of connections, a cellular telephone network, or any other network or medium capable of facilitating communication between computer system 410 and other computers (e.g., remote computing device 473). The network 471 may be wired, wireless or a combination thereof. Wired connections may be implemented using Ethernet, Universal Serial Bus (USB), RJ-6, or any other wired connection generally known in the art. Wireless connections may be implemented using Wi-Fi, WiMAX, and Bluetooth, infrared, cellular networks, satellite or any other wireless connection methodology generally known in the art. Additionally, several networks may work alone or in communication with each other to facilitate communication in the network 471.

It should be appreciated that the program modules, applications, computer-executable instructions, code, or the like depicted in FIG. 4 as being stored in the system memory 430 are merely illustrative and not exhaustive and that processing described as being supported by any particular module may alternatively be distributed across multiple modules or performed by a different module. In addition, various program module(s), script(s), plug-in(s), Application Programming Interface(s) (API(s)), or any other suitable computer-executable code hosted locally on the computer system 410, the remote device 473, and/or hosted on other computing device(s) accessible via one or more of the network(s) 471, may be provided to support functionality provided by the program modules, applications, or computer-executable code depicted in FIG. 4 and/or additional or alternate functionality. Further, functionality may be modularized differently such that processing described as being supported collectively by the collection of program modules depicted in FIG. 4 may be performed by a fewer or greater number of modules, or functionality described as being supported by any particular module may be supported, at least in part, by another module. In addition, program modules that support the functionality described herein may form part of one or more applications executable across any number of systems or devices in accordance with any suitable computing model such as, for example, a client-server model, a peer-to-peer model, and so forth. In addition, any of the functionality described as being supported by any of the program modules depicted in FIG. 4 may be implemented, at least partially, in hardware and/or firmware across any number of devices.

It should further be appreciated that the computer system 410 may include alternate and/or additional hardware, software, or firmware components beyond those described or depicted without departing from the scope of the disclosure. More particularly, it should be appreciated that software, firmware, or hardware components depicted as forming part of the computer system 410 are merely illustrative and that some components may not be present or additional components may be provided in various embodiments. While various illustrative program modules have been depicted and described as software modules stored in system memory 430, it should be appreciated that functionality described as being supported by the program modules may be enabled by any combination of hardware, software, and/or firmware. It should further be appreciated that each of the above-mentioned modules may, in various embodiments, represent a logical partitioning of supported functionality. This logical partitioning is depicted for ease of explanation of the functionality and may not be representative of the structure of software, hardware, and/or firmware for implementing the functionality. Accordingly, it should be appreciated that functionality described as being provided by a particular module may, in various embodiments, be provided at least in part by one or more other modules. Further, one or more depicted modules may not be present in certain embodiments, while in other embodiments, additional modules not depicted may be present and may support at least a portion of the described functionality and/or additional functionality. Moreover, while certain modules may be depicted and described as sub-modules of another module, in certain embodiments, such modules may be provided as independent modules or as sub-modules of other modules.

Although specific embodiments of the disclosure have been described, one of ordinary skill in the art will recognize that numerous other modifications and alternative embodiments are within the scope of the disclosure. For example, any of the functionality and/or processing capabilities described with respect to a particular device or component may be performed by any other device or component. Further, while various illustrative implementations and architectures have been described in accordance with embodiments of the disclosure, one of ordinary skill in the art will appreciate that numerous other modifications to the illustrative implementations and architectures described herein are also within the scope of this disclosure. In addition, it should be appreciated that any operation, element, component, data, or the like described herein as being based on another operation, element, component, data, or the like can be additionally based on one or more other operations, elements, components, data, or the like. Accordingly, the phrase "based on," or variants thereof, should be interpreted as "based at least in part on."

The block diagrams in the Figures illustrate the architecture, functionality, and operation of possible implementations of systems, methods, and computer program products according to various embodiments of the present disclosure. In this regard, each block in the block diagrams may represent a module, segment, or portion of instructions, which comprises one or more executable instructions for implementing the specified logical function(s). In some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams illustration, and combinations of blocks in the block diagrams illustration, can be implemented by special purpose hardware-based systems that perform the specified functions or acts or carry out combinations of special purpose hardware and computer instructions.

It is understood that the system having the features of the independent claim may be implemented to car pout a method as claimed.

## Claims

1. A system for generating artificial depth images of a robotic workstation, the images useful as training data for deep learning networks used for robotic tasks, comprising:
a memory having modules stored thereon; and
a processor for performing executable instructions in the modules stored on the memory, the modules comprising:
a generator network configured as first neural network to receive a pair of data inputs that includes a random noise vector and a computer aided design (CAD) generated depth image, wherein the data inputs are retrieved from training data comprising a plurality of random noise vectors generated by a random noise generator and a plurality of CAD generated depth images of a robotic workstation object, wherein the output of the generator network is an artificial depth image; and
a discriminator network configured as a second neural network to receive a single data input that includes either the artificial depth image or a real depth image in alternation, wherein the real depth image is an image of the workstation scene as seen by a robotic camera, wherein the output of the discriminator network is a predicted label indicating a discriminator decision as to whether an instant input is more likely the real depth image or the artificial depth image;
wherein during training of the generator network, the first and second neural networks are trained in tandem as a generative adversarial network according to a minibatch stochastic gradient descent process, wherein weights of the first and second neural networks are alternately updated to optimize a first cost function of the first neural network and a second cost function of the second neural network, wherein the first cost function minimizes correctly predicted labels by the discriminator network and the second cost function maximizes correctly predicted labels by the discriminator network;
wherein a plurality of training iterations is executed using variations of the CAD generated depth image and the real depth image until the discriminator network is unable to discern the difference between a real depth image and an artificial depth image; and
wherein the generator network, upon training completion, is configured to generate a plurality of realistic artificial depth images by feeding new pairs of data inputs retrieved from the training data, each pair comprising one of the plurality of random noise vectors and one of the plurality of CAD generated depth images.

2. The system of claim 1, wherein the generator network is further configured to:
generate a noise mask based on the CAD generated depth image and the random noise vectors; and
superimpose the noise mask onto the CAD generated depth image to produce the artificial depth scan image.

3. The system of claim 1 or 2, wherein during training of the generator network, the training is determined to be completed when quality of generated artificial depth images is such that the error rate for the decisions by the discriminator network is about 50%.

4. The system of any one of claims 1 ― 3, wherein the CAD generated depth image is based on a 3D CAD model.

5. The system of any one of claims 1 ― 4, wherein the real depth images are:
generated by a depth scan sensor aimed at the workstation scene prior to the training; and
stored as training data.

6. The system of any one of claims 1 ― 5, wherein in response to modifications to the workstation environment, the generator network and the discriminator network are configured to repeat the training process using a new set of real depth images as data inputs to the generator network, wherein the generator network, upon retraining completion, is configured to generate a new plurality of realistic artificial depth images useful to retrain the deep learning network for the robotic tasks.

7. A method for generating artificial depth images of a robotic workstation, the images useful as training data for deep learning networks used for robotic tasks, comprising:
receiving, by a generator network configured as first neural network, a pair of data inputs that includes a random noise vector and a computer aided design (CAD) generated depth image, wherein the data inputs are retrieved from training data comprising a plurality of random noise vectors generated by a random noise generator and a plurality of CAD generated depth images of a robotic workstation object;
generating an artificial depth image as output of the generator network;
receiving, by a discriminator network configured as a second neural network, a single data input that includes either the artificial depth image or a real depth image in alternation, wherein the real depth image is an image of the workstation scene as seen by a robotic camera, wherein the output of the discriminator network is a predicted label indicating a discriminator decision as to whether an instant input is more likely the real depth image or the artificial depth image;
training the first and second neural networks in tandem as a generative adversarial network according to a minibatch stochastic gradient descent process, wherein weights of the first and second neural networks are alternately updated to optimize a first cost function of the first neural network and a second cost function of the second neural network, wherein the first cost function minimizes correctly predicted labels by the discriminator network and the second cost function maximizes correctly predicted labels by the discriminator network;
wherein a plurality of training iterations is executed using variations of the CAD generated depth image and the real depth image until the discriminator network is unable to discern the difference between a real depth image and an artificial depth image; and
wherein the generator network, upon training completion, is configured to generate a plurality of realistic artificial depth images by feeding new pairs of data inputs retrieved from the training data, each pair comprising one of the plurality of random noise vectors and one of the plurality of CAD generated depth images.

8. The method of claim 7, further comprising:
generating a noise mask based on the CAD generated depth image and the random noise vectors; and
superimposing the noise mask onto the CAD generated depth image to produce the artificial depth scan image.

9. The method of claim 7 or 8, wherein during training of the generator network, the training is determined to be completed when quality of generated artificial depth images is such that the error rate for the decisions by the discriminator network is about 50%.

10. The method of any one of claims 7 ― 9, wherein the CAD generated depth image is based on a 3D CAD model.

11. The method of any one of claims 7 ― 10, wherein the real depth images are:
generated by a depth scan sensor aimed at the workstation scene prior to the training; and
stored as training data.

12. The method of any one of claims 7 ― 11, wherein in response to modifications to the workstation environment, further comprising:
repeating the training of the first and the second neural networks using a new set of real depth images as data inputs to the generator network; and
generating, by the generator network, a new plurality of realistic artificial depth images useful to retrain the deep learning network for the robotic tasks.
